(19) Europäisches Patentamt
European Patent Office
Office européen des brevets

(11) Publication number: 0 186 907 B1

(12) # EUROPEAN PATENT SPECIFICATION

(45) Date of publication of patent specification: 09.10.91 (51) Int. Cl.$^5$: G11C 16/06

(21) Application number: 85116578.7

(22) Date of filing: 27.12.85

(54) **Non-volatile semiconductor memory device having an improved write circuit.**

(30) Priority: 28.12.84 JP 277434/84

(43) Date of publication of application: 09.07.86 Bulletin 86/28

(45) Publication of the grant of the patent: 09.10.91 Bulletin 91/41

(84) Designated Contracting States: DE FR GB

(56) References cited:
EP-A- 0 088 912
GB-A- 2 094 086
US-A- 4 446 536

(73) Proprietor: NEC CORPORATION
7-1, Shiba 5-chome Minato-ku
Tokyo 108-01(JP)

(72) Inventor: Higuchi, Misao
c/o NEC Corporation 33-1, Shiba 5-chome
Minato-ku Tokyo(JP)

(74) Representative: Glawe, Delfs, Moll & Partner
Patentanwälte
Postfach 26 01 62 Liebherrstrasse 20
W-8000 München 26(DE)

EP 0 186 907 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### Background of the invention

The present invention relates to a non-volatile semiconductor memory device according to the preamble part of claim 1.

Non-volatile semiconductor memory devices such as Electrically Programmable Read Only Memories (EPROMs), memory contents of which are erasable by ultra-violet ray, have been widely utilized in many kinds of electronic systems. As a memory cell of such EPROMs, an MIS transistor having a stacked gate structure has been mainly employed. The above type MIS transistor has a floating gate located above a channel region via an insulating layer and a control gate located above the floating gate via an insulating layer, the control gate of each MIS transistor is connected to a word line while a drain thereof is connected to a digit line in a matrix form. Memory state of each MIS transistor is corresponded to a value of a threshold voltage which is determined by electric charge accumulated in its floating gate. Upon writing to a memory cell MIS transistor of the above type, potentials at its control gate and drain are raised with its source held at a ground potential so that avalanche breakdown is caused at the drain and hot electrons are injected to the floating gate, whereby a threshold voltage of the memory cell transistor is changed.

A conventional write voltage supply circuit for applying a high write voltage $V_{pp}$ to a control gate of a memory cell transistor in writing is comprised of a series circuit of a switching MIS transistor and a current limiting MIS transistor of a depletion type. Through this series circuit, the high write voltage $V_{pp}$ is applied to a control gate of a memory cell MIS transistor to be written. The purpose of using the current limiting MIS transistor is to limit a value of a current flowing the $V_{pp}$ voltage to the ground potential.

Such a non-volatile semiconductor memory for example is known from GB-A-2 094 086. This kind of non-volatile semiconductor memory would be described with respect to figure 1 later.

However, the current limiting transistor is of a depletion type and therefore, steps in manufacturing the memory is inevitably increased, thus raising cost and reducing yield in manufacturing. In addition, the current limiting transistor must have a relatively large resistance and hence a channel length of the current limiting transistor must be large. This increased a size of a semiconductor chip on which a memory device is fabricated.

### SUMMARY OF THE INVENTION:

It is an object of the present invention to provide a non-volatile memory device which can be easily fabricated.

It is another object of the present invention to provide a non-volatile memory device having a large memory capacity and a high density structure.

The non-volatile semiconductor memory device according to the present invention as set forth in claim 1 is of the type having a plurality of non-volatile memory cells each coupled to a row line and a column line, a row selection circuit for selecting one of the row lines, electric charges on the non-selected row lines being discharged to a reference potential, and a plurality of write voltage application circuits each provided for each row line to apply thereto a write voltage, and is featured in that the write voltage circuit includes a P-channel MIS transistor which is adapted to assume a shallow conductive state at least in a write state and a current flowing through the above P-channel MIS transistor is applied to the row line.

In order to obtain the shallow conductive state of the above P-channel MIS transistor, the gate potential of the P-channel MIS transistor is adjust at the voltage which is lower than the write voltage $V_{pp}$ by 2 to 3 volts.

According to the present invention, usage of a depletion MIS transistor in each write voltage application circuit is effectively avoided.

### BRIEF DESCRIPTION OF THE DRAWINGS:

Fig. 1 is a schematic circuit diagram of a non-volatile memory device according to prior art;
Fig. 2 is a schematic circuit diagram showing a major part of a non-volatile memory device according to the present invention;
Fig. 3 is a timing chart showing operation of the memory of Fig. 2;
Fig. 4 is a schematic circuit diagram showing a practical memory array according to the present invention; and
Fig. 5 is a schematic circuit diagram showing a constant voltage generating circuit used in the memory of Figs. 3 and 4.

### DETAILED DESCRIPTION OF THE INVENTION:

Referring to Fig. 1, a major part including a write voltage applying circuit of a non-volatile memory device according to prior art is explained.

Although a plurality of memory cells are arranged in a matrix form in a practical product, one memory cell and a writing scheme for this memory cell are illustrated in Fig. 1 for easier understanding.

The memory cell transistor $M_{11}$ is a so-called floating gate MIS transistor. Its floating gate is left unconnected to any circuit line while its control gate is connected to a word line $X_1$. A source of the transistor is connected to a ground potential while a drain of the transistor $M_{11}$ is connected to a digit line $B_{11}$ to which drains of other memory cell transistors in the same column (not shown) are connected. The digit line $B_{11}$ is connected to a load transistor $Q_L$ and an input of an output amplifier 14 through a column selection circuit 13 which is selected by a column selection signal $Y_i$. A row driver circuit 11 is comprised of a P-channel MIS transistor $Q_{11}$, an N-channel MIS transistor $Q_{12}$ and an N-channel depletion type MIS transistor $Q_{14}$ which form and inverter circuit receiving a row decoder signal $D_{11}$. Throughout the explanation, MIS transistors which are not mentioned as depletion MIS transistors are enhancement MIS transistors. A write voltage supply circuit 12 is composed of an N-channel MIS transistor $Q_{13}$ and an N-channel depletion MIS transistor $Q_{15}$ connected in series between a write voltage $V_{pp}$ and the word line $X_1$. In a write operation for the memory cell transistor $M_{11}$, a control signal $C_{12}$ is made high to make the transistor $Q_{13}$ conductive, while a control signal $C_{11}$ is rendered low to made the transistors $Q_{14}$ in high resistance state and the row decoder signal $D_{11}$ is at high thereby to make the transistor $Q_{12}$ non-conductive. Therefore, a potential at the word line $X_1$ is made at nearly the write voltage $V_{pp}$ through the transistors $Q_{13}$ and $Q_{15}$. The write voltage $V_{pp}$ is higher than a power voltage $V_{cc}$. For typical case, $V_{cc}$ is about 5 V and $V_{pp}$ is about 20 V. The column selection circuit 13 connects the digit line to $V_{pp}$ by a selected level of the column decoder signal $Y_i$. Thus, hot-electrons are injected to the floating gate of the transistor $M_{11}$ to raise the threshold voltage of the transistor $M_{11}$. In the case where the memory cell transistor $M_{11}$ is not selected in a write operation, the row decoder signal $D_{11}$ assumes a low level to render the transistor $Q_{12}$ conductive so that the potential at the word line $X_1$ is made nearly the ground potential. In this instance, the transistor $Q_{15}$ serves as a current limiter for suppressing an electric current flowing to the ground through the transistor $Q_{12}$ from $V_{pp}$. However, the transistor $Q_{15}$ is of a depletion type and hence manufacturing of the memory device has been complexed and prolonged. Furthermore, the transistor $Q_{15}$ must have a large on-resistance and therefore, the transistor $Q_{15}$ is required to have a long channel region, causing the enlargement of a chip size.

Referring to Fig. 2, a major part of the non-volatile semiconductor memory according to the present invention will be described.

Similarly to Fig. 1, one memory cell transistor $M_{21}$ is representatively illustrated with a write scheme for the memory cell transistor $M_{21}$. A write voltage circuit 22 is comprised of a P-channel MIS transistor $Q_{24}$ and a P-channel MIS transistor $Q_{25}$ connected in series between the write voltage $V_{pp}$ and the word line $X_2$ connected to the control gate of the cell transistor $M_{21}$. A word driver circuit 21 includes a CMOS type inverter composed of a P-channel MIS transistor $Q_{21}$ and an N-channel MIS transistor $Q_{22}$ receiving a word decoder signal $D_{21}$. An output of the inverter is coupled to the word line $X_2$ through a source-drain path of an N-channel MIS transistor $Q_{23}$ receiving a predetermined potential $C_{21}$ at its gate. A source of the memory cell transistor $M_{21}$ is connected to the ground potential while its drain is connected to a digit line $B_{21}$ which is connected to a common node $N_3$ of a read-write selection switch SW via a column selection circuit 24 controlled by a digit decoder signal $Y_i$. The switch SW connects the common node $N_3$ to the write voltage $V_{pp}$ via a contact $N_1$ in a write state and to a node $N_2$ to which the power voltage $V_{cc}$ is applied through an N-channel MIS transistor $Q_{26}$ serving as a load element in a read state. An input of an output amplifier 25 is connected to the node $N_2$. In this arrangement, the significant feature resides in the write voltage apply circuit 22 made of P-channel MIS transistors $Q_{24}$ and $Q_{25}$. A voltage $V_0$ generated by a voltage generator 23 is applied to the gate of the transistor $Q_{24}$. This voltage has a value slightly lower than Vpp so that the transistor $Q_{24}$ assumes a shallow conductive state. In other words, the transistor $Q_{24}$ takes a conductive state, but its on-resistance is relatively large. Accordingly, the transistor $Q_{24}$ serves as a current limitter of a current flowing into the ground via the transistor $Q_{22}$ in a write state. The transistor $Q_{25}$ serves as a switch and assumes a conductive state in a write operation and a non-conductive state in a read operation in response to a control signal $C_{22}$. In a write state, the transistor $Q_{23}$ takes a high impedance and the word line $X_2$ becomes Vpp which is higher than $C_{21}$, i.e., $Q_{23}$ thereby isolates the word line $X_2$ from $V_{cc}$. Fig. 5 shows an example of a circuit of the voltage generator 25. A P-channel MIS transistor $Q_{31}$, an N-channel depletion MIS transistor $Q_{33}$ and an N-channel MIS transistor $Q_{34}$ are connected in series between the write power voltage Vpp and the ground potential. A P-channel MIS transistor $Q_{32}$ is connected in parallel with the transistor $Q_{31}$. A control signal $\overline{C_{22}}$ of the opposite phase with respect to the control signal $C_{22}$ is applied to the gates of the transistors $Q_{32}$ and $Q_{34}$. In a read state, the control signal $\overline{C_{22}}$ assumes the ground potential so that the transistor $Q_{32}$ takes a conductive state while the transistor $Q_{34}$ takes a non-conductive state. Accordingly, the output voltage $v_0$ is approximately equal to Vpp. While in a write state, the control signal $\overline{C_{22}}$ as-

sumes a high level close to Vpp so that the transistor $Q_{34}$ is conductive and the transistor $Q_{32}$ is non-conductive. As a result, the voltage $V_0$ takes an intermediate value "Vpp-$\alpha$" in which $\alpha$ is usually 2 to 3 volts for the case of Vpp = 20 V.

Thus, the transistor $Q_{24}$ of the circuit takes a conductive state in a write state and a non-conductive state in a read state in response to the value of $V_0$.

Fig. 3 shows waveforms in operations of the memory shown in Figs. 2 and 5.

$T_1$ shows a read period in which a period $T_{1-1}$ shows the case where the memory cell transistor $M_{21}$ is not selected. During the period $T_{1-1}$, the row decoder signal $D_{21}$ is at high to make the transistor $Q_{22}$ conductive. The potential $C_{21}$ is kept at $V_{cc}$ throught the whole operation. While the control signal $C_{22}$ and the voltage $V_0$ are approximately at Vpp so that the transistors $Q_{24}$ and $Q_{25}$ are non-conductive. Accordingly, the word line $X_2$ is at low in level. A period $T_{1-2}$ shows the case where the cell transistor $M_{21}$ is selected in a read cycle. In this instance, the row decoder signal $D_{21}$ is the ground potential and the transistor $Q_{21}$ is conducting. While the transistors $Q_{24}$ and $Q_{25}$ are still non-conducting. Therefore, the word line $X_2$ is raised in potential close to $V_{cc}$ via the transistors $Q_{21}$ and $Q_{23}$, while the digit line $B_{21}$ is connected to the node $N_2$ via the circuit 24, and the switch SW.

A write cycle is shown as $T_2$. A period $T_{2-1}$ shows the case where the cell transistor is not selected. During the period $T_{2-1}$, the control signal $c_{22}$ is approximately at the ground potential and-the voltage $v_0$is at the intermediate level of (Vpp-$\alpha$) so that the transistors $Q_{24}$ and $Q_{25}$ are conductive. However, the transistor $Q_{22}$ is conductive in response to the high level of $D_{21}$. Therefore, the word line $X_2$ is made approximately at the ground level through $Q_{22}$ and $Q_{23}$. In this instance, although there is a current path from Vpp to the ground level via $Q_{24}$ and $Q_{25}$, the transistor $Q_{24}$ operates to limit the current flowing therethrough. Thus, the potential of the word line $X_2$ is effectively set at the ground potential and the power consumption due to this current is also reduced.

A period $T_{2-2}$ is the case where the cell transistor $M_{21}$ is selected. In this instance, the row decoder signal $D_{21}$ is at the low level to make the transistor $Q_{22}$ non-conductive and the transistor $Q_{21}$ conductive. Therefore, the potential of the word line is raised to Vpp via the transistors $Q_{24}$ and $Q_{25}$, achieving the selection of the word line $x_2$. During this period $T_{2-2}$, Vpp is also applied to the drain of $M_{21}$ via the circuit 24 and the switch SW.

Fig. 4 shows a practical layout where a plurality of memory cell transistors are arranged in a matrix form. In Fig. 4, the portions corresponding to those in Fig. 2 are designated by similar references. Each consecutive four word lines, e.g. $X_{11}$ to $X_{14}$ and their word driving schemes are classified into blocks $BL_l$ to $BL_m$. Each of the blocks $BL_l$ to $BL_m$ has the same structure and the block $BL_l$ is representatively illustrated. Main row decoders $RD_l$ to $RD_m$ receiving row address signals $a_0$ to $a_i$, $\overline{a_0}$ to $\overline{a_i}$ provided for the blocks $BL_l$ to $BL_m$. Each of the main row decoders $RD_l$ to $RD_m$ selects its corresponding block, e.g. $BL_l$. For example, the low level of the output $D_1$ of the decoder $RD_1$ selects the block $BL_1$. A NOR type row address driver 21'-1 receives the output $D_1$ and a sub row decoded signal $\overline{AX_1}$ and select the word line when both of $D_1$ and $\overline{AX_1}$ are low. Other row address drivers 21'-2 to 21'-4 have the same structure as 21'-1 except different sub row decoded signals $\overline{AX_2}$, $\overline{AX_3}$ and $\overline{AX_4}$ are applied. The signals $\overline{AX_1}$ to $\overline{AX_4}$ are the signals obtained by decoding two bits of row address signals which are not applied to the decoders $RD_l$ to $RD_m$. The write voltage apply circuit 23'-1 to 23'-4 are connected between the write voltage Vpp and the word lines $X_{11}$ to $X_{14}$ in the block $BL_1$. The signal $C_{22}$ and the voltage $V_0$ are applied to all the write voltage circuits in common. Although not shown in Fig. 4, column selection scheme such as the circuits 24, switch SW, the transistor $Q_{26}$ and the amplifier 25 in Fig. 2 is provided in a known way.

As has been described above, according to the present invention, a non-volatile semiconductor memory having a high density structure can be fabricated without using depletion MIS transistors.

## Claims

1. A non-volatile semiconductor memory device comprising a plurality of row lines (X11-X14), a plurality of column lines (B11-B21), a plurality of non-volatile memory cells (M11-M4m) each coupled to one of said row lines and one of said column lines, a row selection circuit (21, RD1, 21'-1-21'-4) responsive to row address information for selecting one of said row lines, the selected row line being allowed to assume a selection level, potentials at the non-selected row lines being discharged to a reference voltage, and a plurality of write voltage application circuits (22, 23'-1-23'-4) each coupled to each one of said row lines for applying a write voltage (Vpp) thereto in a write state, each of said write voltage application circuits including a current limiting MIS transistor (Q24) adapted to take a shallow conductive state and means (Q25) for connecting a source-drain path of said current limiting transistor between said row line and said write voltage, **characterized** in that said current limiting transistor is of an enhancement type.

2. The memory device according to claim 1, **characterized** in that said current limiting transistor (Q24) is a first P-channel MIS transistor and a gate of said first P-channel transistor is supplied with a potential which is lower than said write voltage (Vpp).

3. The memory device according to claim 1 or 2, **characterized** in that said connecting means includes a switching MIS transistor (Q25) having a source-drain path connected in series with the source-drain path of said current limiting transistor (Q24), and that said switching transistor is rendered conductive in a write state and non-conductive in a read state.

4. The memory device according to any of claims 1 to 3, **characterized** in that said row selection circuit includes a plurality of driver circuits (21'-1 to 21'-4) each provided for each one of said row lines and a plurality of connecting MIS transistors (Q23) each coupled between the output of one of said driver circuits and one of said row lines.

5. The memory device according to any of claims 1 to 4, **characterized** in that each of said memory cells (M11-M4m) includes a floating gate type MIS transistor having a floating gate and a control gate connected to one of said row lines.

**Revendications**

1. Dispositif de mémoire à semi-conducteur rémanente comprenant une multitude de lignes de rangées (X11 à X14), une multitude de lignes de colonnes (B11 à B21), une multitude de cellules de mémoire rémanente (M11 à M4m) chacune couplée à une ligne desdites lignes de rangées et une ligne desdites lignes de colonnes, un circuit de sélection de rangée (21, RD1, 21'-1 à 21'-4) sensible à l'information d'adresse de rangée pour sélectionner une ligne desdites lignes de rangées, la ligne de rangées sélectionnée étant autorisée à prendre un niveau sélectionné, les potentiels au niveau des lignes de rangées non sélectionnées étant déchargés à une tension de référence, et une multitude de circuits d'application de tension d'écriture (22, 23'-1 à 23'-4) chacun couplé à chacune des lignes de rangées pour appliquer une tension d'écriture (Vpp) à celui-ci dans un état d'écriture, chacun des circuits d'application de tension d'écriture comportant un transistor semi-conducteur à métal-isolant de limitation de courant (Q24) prévu pour prendre un état peu conducteur et un moyen (Q25) pour connecter un trajet source-drain du transistor de limitation de courant entre la ligne de rangées et la tension d'écriture, caractérisé en ce que le transistor de limitation de courant est d'un type à enrichissement.

2. Dispositif de mémoire selon la revendication 1, caractérisé en ce que le transistor de limitation de courant (Q24) est un premier transistor semi-conducteur à métal-isolant de canal P et une grille du premier transistor à canal P reçoit un potentiel qui est inférieur à la tension d'écriture (Vpp).

3. Dispositif de mémoire selon la revendication 1 ou 2, caractérisé en ce que le moyen de connexion comporte un transistor semi-conducteur à métal-isolant de commutation (Q25) ayant un trajet source-drain connecté en série avec le trajet source-drain du transistor de limitation de courant (Q24), et en ce que le transistor de commutation est rendu conducteur en état d'écriture et bloqué en état de lecture.

4. Dispositif de mémoire selon l'une quelconque des revendications 1 à 3, caractérisé en ce que le circuit de sélection de rangée comporte une multitude de circuits de commande (21'-1 à 21'-4), chacun prévu pour chaque ligne des lignes de rangées et une multitude de transistors semi-conducteurs à métal-isolant de connexion (Q23) chacun couplé entre la sortie d'un circuit des circuits de commande et une ligne des lignes de rangées.

5. Dispositif de mémoire selon l'une quelconque des revendications 1 à 4, caractérisé en ce que chacune des cellules de mémoire (M11 à M4m) comporte un transistor semi-conducteur à métal-isolant du type à grille flottante ayant une grille flottante et une grille de commande connectée à une ligne des lignes de rangées.

**Patentansprüche**

1. Nicht-flüchtige Halbleiterspeicheranordnung mit einer Anzahl Zeilenleitungen (X11-X14), einer Anzahl Spaltenleitungen (B11-B21), einer Anzahl nicht-flüchtiger Speicherzellen (M1l-M4m), die jede mit einer der Zeilenleitungen und einer der Spaltenleitungen gekoppelt sind, einem Zeilen-Wählschaltkreis (21,RD1,21'-1-21'-4), der auf die Zeilenadresseninformation anspricht, um eine der Reihenlinien zu wählen, wobei die gewählte Reihenlinie einen gewählten Pegel einnehmen darf, und die Potentiale an den nicht gewählten Zeilenleitungen auf eine Referenzspannung entladen werden, und einer Anzahl von Schreibspannung-Anlegeschaltkreisen (22,23'-1-23'-4), die jeweils mit einer der Zeilenleitungen gekoppelt sind, um an diese in einem Schreibzustand eine Schreibspannung ($V_{pp}$) anzulegen, wobei jeder der Schreibspannungs-Anlegeschaltkreise einen strombegrenzenden MIS-Transistor (Q24) aufweist, der einen Oberflächen-leitfähigen Zustand annehmen kann und Mittel (Q25) hat, um zwischen der Zeilenleitung und der Schreibspannung einen Source-Drain-Pfad des strombegrenzenden Transistors zu schalten, dadurch **gekennzeichnet,** daß der strombegrenzende Transistor vom Anreicherungstyp ist.

**2.** Speicheranordnung nach Anspruch 1, dadurch **gekennzeichnet,** daß der strombegrenzende Transistor (Q24) ein erster P-Kanal-MIS-Transistor ist, und ein Gate des ersten P-Kanal-Transistors mit einem Potential gespeist wird, das niedriger als die Schreibespannung ($V_{pp}$) ist.

**3.** Speicheranordnung nach Anspruch 1 oder 2, dadurch **gekennzeichnet,** daß die Anschlußmittel einen Schalt-MIS-Transistor (Q25) aufweisen, dessen Source-Drain-Pfad in Reihe mit dem Source-Drain-Pfad des strombegrenzenden Transistors (Q24) geschaltet ist, und daß der Schalttransistor in einem Schreibezustand leitend und in einem Lese-Zustand nicht leitend gemacht wird.

**4.** Speicheranordnung nach jedem der Ansprüche 1 - 3, dadurch **gekennzeichnet,** daß der Reihen-Wählschaltkreis eine Anzahl von Treiber-Schaltkreisen (21'-1 bis 21'-4), die jeweils für jede der Reihenlinien vorgesehen sind, und eine Anzahl von Anschluß-MIS-Transistoren (Q23) aufweist, die jeweils zwischen dem Ausgang eines der Treiber-Schaltkreise und einem der Reihenlinien gekoppelt sind.

**5.** Speichereinrichtung nach jedem der Ansprüche 1-4, dadurch **gekennzeichnet,** daß jede der Speicherzellen (M1l-M4m) einen MIS-Transistor mit freischwebendem Gate aufweist, und ein Steuergate mit einer der Reihenlinien verbunden ist.

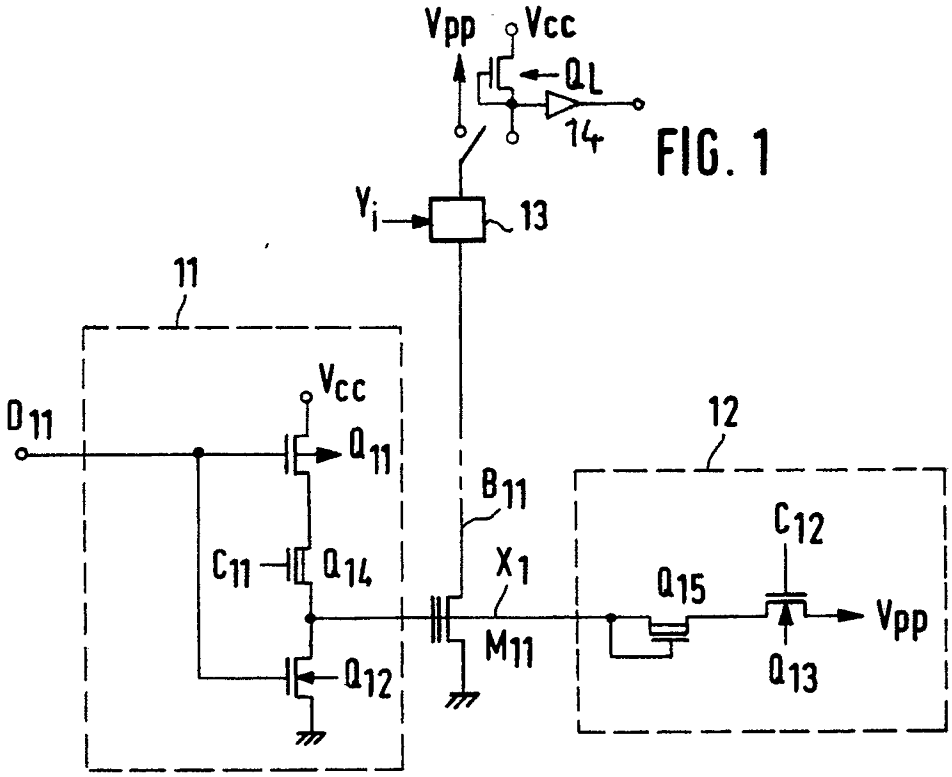

Vpp
Vcc
QL
14
13
Yi
11
D11
Vcc
Q11
C11
Q14
Q12
B11
X1
M11
12
C12
Q15
Q13
Vpp


FIG. 1

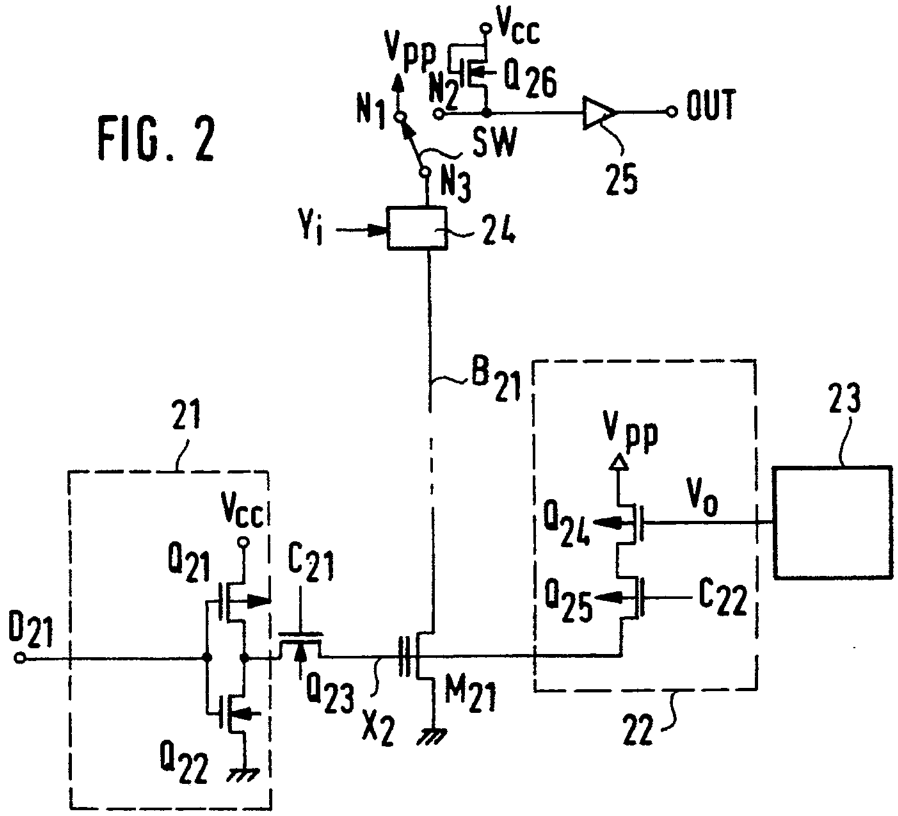

Vpp
Vcc
N1
N2
Q26
SW
OUT
25
N3
Yi
24
B21
21
23
Vpp
Vo
Q24
Q25
C22
Vcc
Q21
C21
D21
Q23
X2
M21
Q22
22


FIG. 2

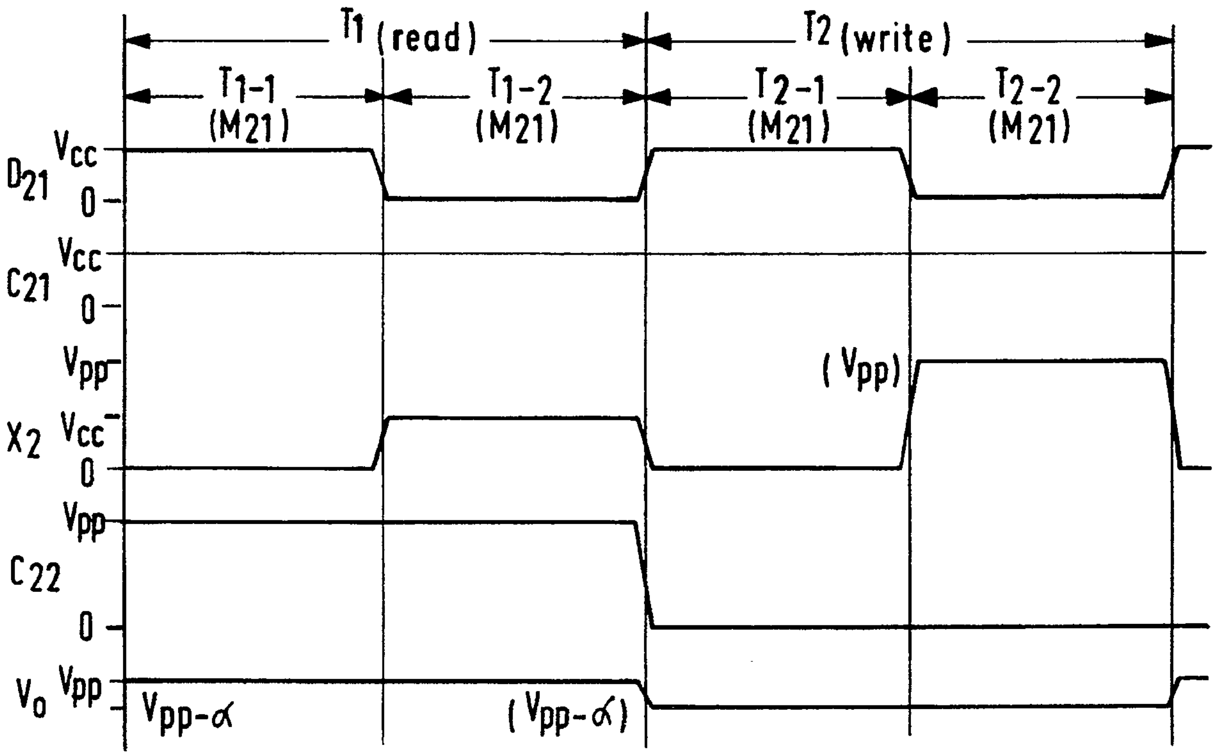
T1 (read)
T2 (write)
T1-1 (M21)
T1-2 (M21)
T2-1 (M21)
T2-2 (M21)
D21
Vcc
0
C21
Vcc
0
Vpp
X2
Vcc
0
(Vpp)
Vpp
C22
0
Vo
Vpp
Vpp-α
(Vpp-α)

FIG. 3

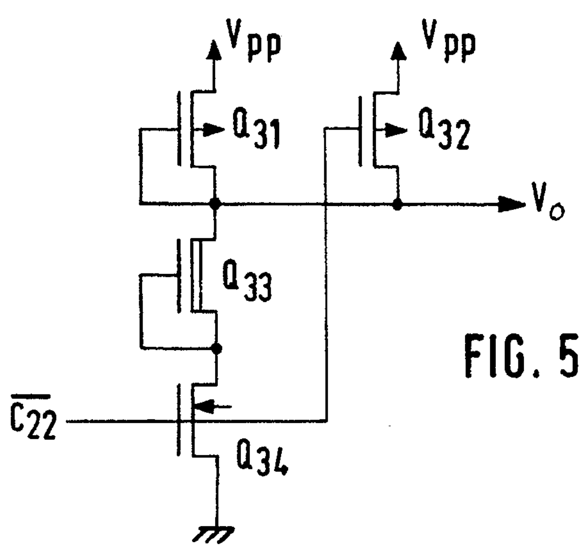
Vpp
Vpp
Q31
Q32
Vo
Q33
C22
Q34

FIG. 5

FIG. 4

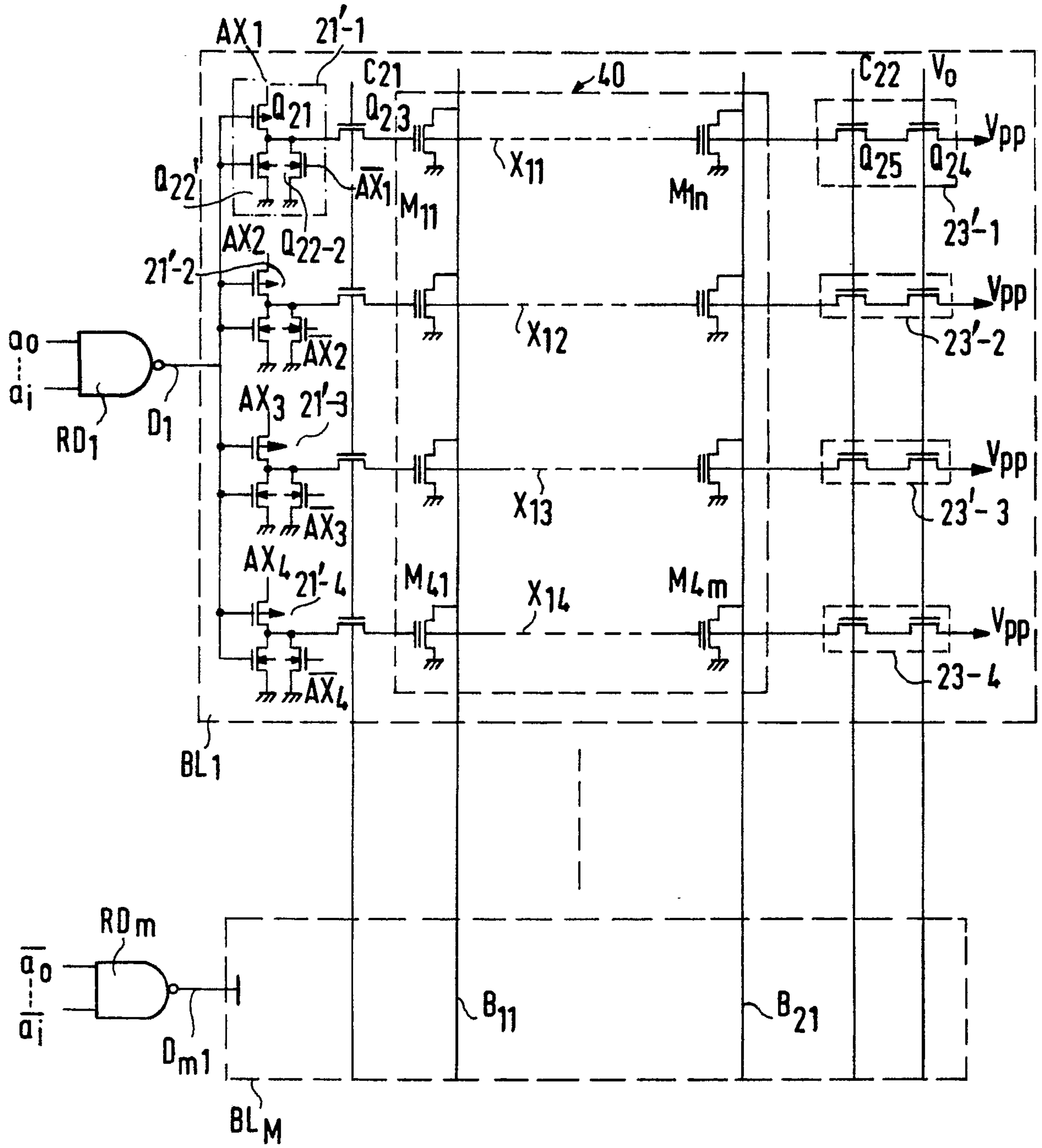
AX1
21'-1
C21
40
C22
V0
Q21
Q23
Vpp
X11
Q25
Q24
Q22'
AX1
M11
M1n
23'-1
AX2
Q22-2
21'-2
Vpp
a0
ai
X12
23'-2
AX2
RD1
D1
AX3
21'-3
Vpp
X13
23'-3
AX3
AX4
21'-4
M41
X14
M4m
Vpp
23-4
AX4
BL1
RDm
a0
ai
B11
B21
Dm1
BLM